# EUROPEAN PATENT APPLICATION

(11) **EP 1 742 091 A1**
(43) Date of publication of application: **10.01.2007**
(21) Application number: 06013407.9
(22) Date of filing: 28.06.2006
(51) Int. Cl.: G02B 5/18, G02B 1/04, G03F 7/00

(54) **Optical device with refractive and diffractive properties**

(30) Priority: 06.07.2005 US 175540
(71) Applicant: Avago Technologies General IP Pte. Ltd., Singapore 768923 (SG)
(72) Inventor: Law, Benjamin Pain-Fong, Fremont CA 94539 (US); Coleman, Christopher L., Santa Clara CA 95050 (US); Giboney , Kirk S., Santa Rosa CA (US)
(74) Representative: Schoppe, Fritz

(57) **Abstract**

An optical device (800) is formed of two discrete relief structures (840 and 850) to provide refractive and diffractive properties. A first discrete relief structure (840) has a curved surface to provide the refractive properties, and a second discrete relief structure (850) disposed over the first discrete relief structure (840) includes one or more layers of an optically-transparent polymer material to provide the diffractive properties. The one or more layers in the second discrete relief structure (850) define a surface curvature envelope (810) formed of discontinuous diffractive features (820) that produce the diffractive properties of the optical device (800).

## Description

### BENEFIT CLAIM UNDER 35 U.S.C. § 120

This application is a continuation-in-part of prior U.S. Non-provisional Application for Patent Serial No. 10/137,630 filed on May 2, 2002.

### BACKGROUND OF THE INVENTION

Microlens fabrication is an important technique in the quest to build compact fiber optical telecommunications devices capable of operating at terabit speeds. In these compact devices, the lenses that are used to align and focus incoming and outgoing light signals are becoming smaller and are being placed closer to miniature detectors or light sources, such as Vertical Cavity Surface Emitting Lasers (VCSELs).

Various types of microlens fabrication techniques have been used in the optical telecommunications industry, such as polymer stamping or molding processes and polymer reflow processes. However, the typical polymers used in the polymer stamping or molding processes and polymer reflow processes are low viscosity polymers that do not perform well at temperatures above 250°C. In applications where the assembly fabrication temperature may be in excess of 300 °C, the optical properties of the microlens array may deteriorate due to shape deformation and material discoloration caused by the high fabrication temperatures. In addition, low viscosity polymers are typically not capable of producing thick lenses, which may be required depending upon the application. Furthermore, the lens shapes attainable by typical photoresist materials are limited by the surface tension of the photoresist in liquid form.

Therefore, what is needed is an economical lens fabrication technique that produces lenses capable of withstanding subsequent high processing temperatures and allows the lens shape and height to be controlled.

### SUMMARY OF THE INVENTION

Embodiments in accordance with the invention provide an optical device including two discrete relief structures to provide refractive and diffractive properties. A first discrete relief structure has a curved surface to provide the refractive properties, and a second discrete relief structure disposed over the first discrete relief structure includes one or more layers of an optically-transparent polymer material to provide the diffractive properties. The one or more layers in the second discrete relief structure define a surface curvature envelope formed of discontinuous diffractive features that produce the diffractive properties of the optical device.

### BRIEF DESCRIPTION OF THE DRAWINGS

The disclosed invention will be described with reference to the accompanying drawings, which show important sample embodiments of the invention and which are incorporated in the specification hereof by reference, wherein:
FIG. 1 is a flowchart illustrating exemplary steps for fabricating a micro-optics device in accordance with embodiments of the invention;
FIGs. 2A-2G are cross-sectional views illustrating the fabrication of a micro-optics device in accordance with one embodiment of the invention;
FIG. 3 is a flowchart illustrating exemplary steps for fabricating a micro-optics device in accordance with the embodiment shown in FIGs. 2A-2G;
FIGs. 4A-4F are cross-sectional views illustrating the fabrication of a micro-optics device in accordance with another embodiment of the invention;
FIG. 5 is a flowchart illustrating exemplary steps for fabricating a micro-optics device in accordance with the embodiment shown in FIGs. 4A-4F;
FIGs. 6A-6I are cross-sectional views illustrating the fabrication of a micro-optics device in accordance with another embodiment of the invention;
FIG. 7 is a flowchart illustrating exemplary steps for fabricating a micro-optics device in accordance with the embodiment shown in FIGs. 6A-6I;
FIG. 8 is a perspective view of an exemplary optical device with refractive and diffractive properties fabricated in accordance with embodiments of the present invention; and
FIG. 9 is a cross-sectional view of the optical device of FIG. 8.

### DETAILED DESCRIPTION OF EXEMPLARY EMBODIMENTS

As used herein, the term "resist" is defined as a polymer resist material that is transparent to optical wavelengths equal to or greater than 350 nm and that has a viscosity sufficient to allow stacking of layers. For example, the viscosity of the polymer resist material can be between 2,000 and 100,000 centipoise, 2,500 and 100,000 centipoise, 3,000 and 100,000 centipoise, 3,500 and 100,000 centipoise, 4,000 and 100,000 centipoise, 4,500 and 100,000 centipoise or 5,000 and 100,000 centipoise. The high viscosity (e.g., at or above 2,000 centipoise) of the resist material allows for thick films (up to mm range) to be produced, and therefore, thick lenses to be produced. Furthermore, the optical transparency of the resist material enables the resist to be used as a lens material and allows the thick films produced by the resist to be thermally cured down to the substrate.

In one embodiment, the resist is an epoxy-based polymer resist. Epoxy-based polymer resist materials are able to be flowed at low temperatures before the polymer becomes cross-linked and, after subsequent processing, the materials are stable at temperatures above 250 °C (i.e., the resist will not reflow during subsequent processing as many other polymers do). An example of an epoxy-based polymer resist is SU-8, which is a commercially available resist developed by IBM and sold by MicroChem Corporation. SU-8 becomes chemically inert and immovable once exposed to ultraviolet (UV) light and thermally cured.

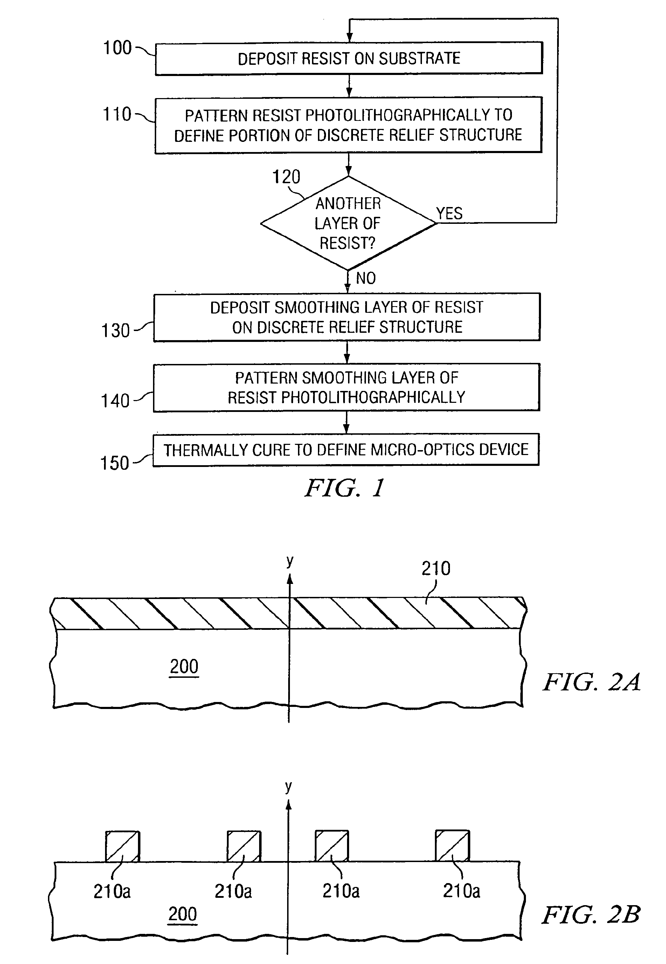

FIG. 1 illustrates exemplary steps for fabricating a micro-optics device in accordance with embodiments of the invention. A layer of the resist is deposited onto a substrate (step 100) and patterned photolithographically to define a first lens layer (step 110). The substrate can be a substrate transparent to light within a particular range of wavelengths (e.g., visible, x-ray, infrared) and include one or more layers of an anti-reflection material, such as dielectric materials of appropriate optical indices and thicknesses. In other embodiments, for reflection optics applications, the substrate need not be transparent, and can include one or more layers of a reflection material, such as metallic materials and/or dielectric materials of appropriate optical indices and thicknesses.

To obtain the desired geometry of the micro-optics device, additional layers of the resist (step 120) can be deposited (step 100) and patterned photolithographically (step 110) to build a complete lens structure. A final smoothing layer of the resist can be deposited over the lens structure (step 130), patterned (step 140) and thermally cured (step 150) to provide a smooth surface for the micro-optic device. For example, the substrate can be placed either on a hot plate or in an oven at a temperature between 90 °C and 120 °C. However, it should be understood that other temperatures may be used, depending upon the materials involved. The resulting micro-optics device can contain, for example, one or more of each of the following types of microlenses: concave lenses, convex lenses, circular lenses, elliptical shape lenses, prisms, Fresnel lenses, gratings and diffractive optics. Moreover, the micro-optics device fabrication technique enables easy integration of the micro-optics device into an assembly and allows the micro-optics device to be packaged together with other IC components economically.

In one embodiment, as shown in FIGs. 2A-2G, a micro-optics device, such as an array of microlenses, is fabricated in a series of pattern steps. In each step, layer of an epoxy-based, negative-working, photo-definable polymer resist 210 is deposited on substrate 200, such as quartz, glass, silicon, ceramic, plastic, flexible thin films and other types of materials. Resist 210 can be deposited using any known deposition process, such as, for example, spin-coating. An example of a spin-coating process is as follows: (1) place the substrate on a vacuum chuck; (2) dispense the resist over the substrate in a static mode; (3) spin the substrate up to a set speed (e.g., 500-5000 rpm); (4) maintain the set speed for certain period of time; and (5) ramp down the speed until the substrate stops spinning. During the spin cycle, the resist spreads and coats the surface of the substrate. Excess resist is spun off in order to produce the desired resist film thickness. The result of the deposition process is layer of resist 210 overlying substrate 200, as shown in FIG. 2A.

After deposition of layer of resist 210 onto substrate 200, the edges of the lenses are defined photolithographically, as shown in FIG. 2B. For example, in a standard photolithography process, resist 210 is exposed to ultraviolet (UV) light (e.g., 350 nm - 400 nm) with a photo-mask at room temperature, and then baked at a typical temperature of between 95 °C and 120 °C (although other temperatures may be used, depending upon the materials involved). The UV light changes the property of exposed resist 210 to be easy or difficult to dissolve in a developer solution based on the tone of resist 210 (negative or positive tone). Negative-working polymer resist 210 shown in FIG. 2B becomes cross-linked (i.e., hard) in the exposed regions, and therefore, resistant to developer solution. The unexposed regions of resist 210 dissolve in the developer solution, leaving the desired pattern of one or more stacks 210a of the first layer of resist, as shown in FIG. 2B. For example, in some embodiments, the developer solution can be propylene glycol monomethyl ether acetate (PGMEA). However, it should be understood that other developer solutions may be used, depending upon the materials involved.

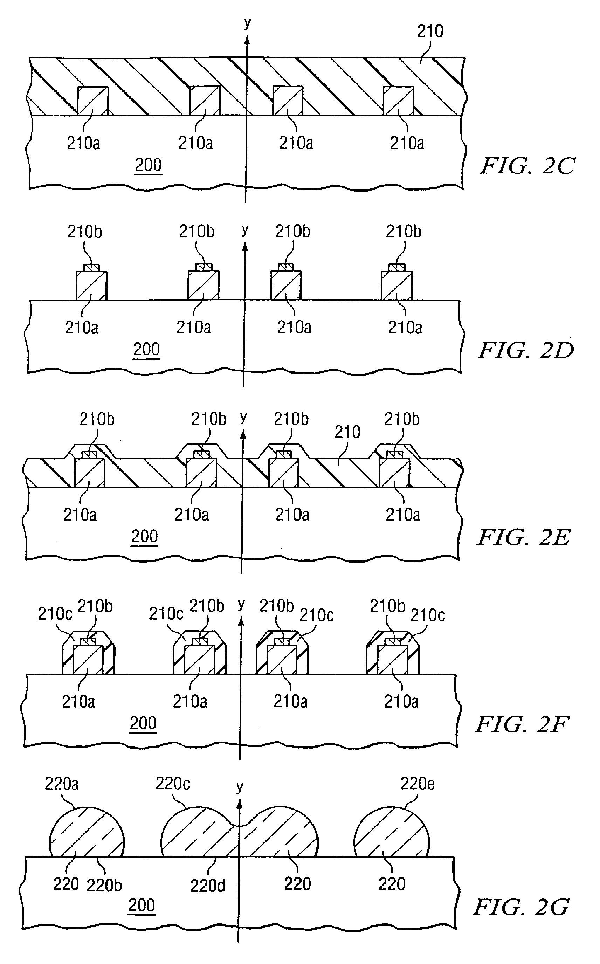

In FIG. 2C, second layer of resist 210 is shown deposited (e.g., spin-coated) over patterned stacks 210a in the first layer of resist. Second layer of resist 210 is also patterned photolithographically to define one or more stacks 21 0b of the second layer of resist overlying one or more of the stacks 210a of the first layer of resist. As shown in FIG. 2D, second layer stacks 210b are smaller in area than first layer stacks 210a to create "pedestal" stacks of resist material. Subsequent layers of resist, not shown, can be deposited and defined in a stair case elevation pattern, where bottom pedestal 210a has the largest area and top pedestal 210b has the smallest area. The height and curvature of the lens is determined by the number of resist layers and the outer edge diameters of each resist layer.

As shown in FIG. 2E, final smoothing layer of resist 210 is spin-coated over previous patterned stacks 210a and 210b of resist. It should be noted that final layer of resist 210 can have a variable viscosity that is less than the viscosity of other resist layers (e.g., less than 2,000 centipoise). Final layer of resist 210 is also exposed to UV light with the photo-mask used in defining the edges of the lenses for the first layer of resist and developed, such that final patterned layer of resist 210c covers all other stacks 210a and 21 0b of resist, as shown in FIG. 2F. Resulting stack of resist layers 210a, 210b and 210c is thermally cured (i.e., soft baked) to allow final patterned layer 21 0c to flow smoothly over other resist stacks 210a and 210b to cover stacks 210a and 210b and fill in between stacks 210a and 210b. Surface tension resulting from the thermal cure process pulls the shape of final patterned layer 210c of resist into lens 220 having a curved surface, as shown in FIG. 2G. To finalize the shape and size of lens 220, lens 220 is blanket exposed (i.e., no mask is used) with UV to cross-link the polymer material in order to harden lens 220.

The fabrication process produces lithographically defined geometries in a polymer. For example, the fabrication process enables control of various lens parameters, such as the height, diameter and figure of the lens. FIG. 2G further illustrates several examples of lens parameters that are variable using the fabrication process described above. The parameters are as follows: curvature of a concave lens 220a; diameter of a concave lens 220b; curvature of a convex lens 220c; diameter of a convex lens 220d; and height of the lenses 220e. However, it should be understood that the lens parameters capable of being controlled by the fabrication process of the invention are not limited to those shown in FIG. 2G, but rather can be extended to any lens geometry.

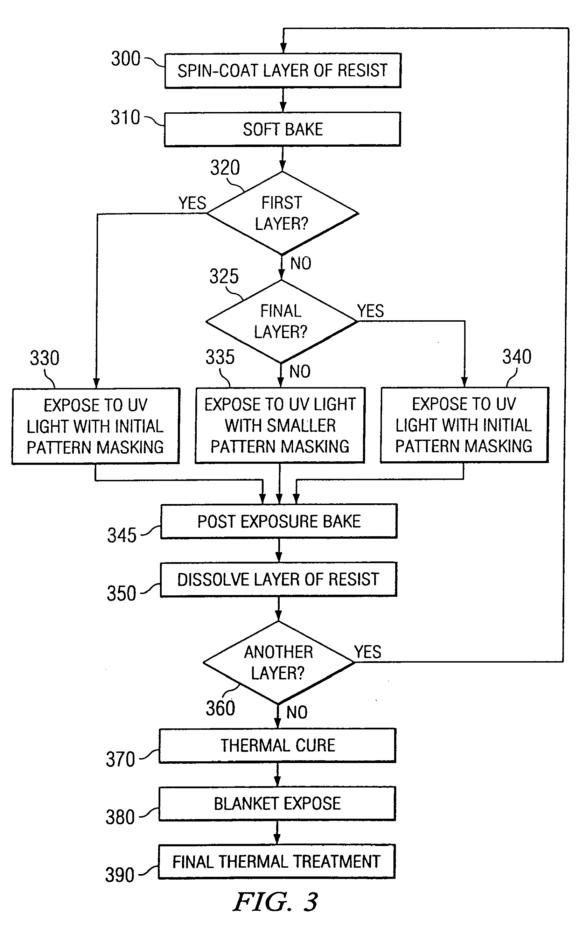

FIG. 3 is a flowchart illustrating exemplary steps for fabricating a micro-optics device in accordance with the embodiment shown in FIGs. 2A-2G. An initial layer of an epoxy-based negative-working photo-definable polymer resist is spin-coated onto a substrate (step 300). If desired, the substrate with the layer of resist thereon can be thermally cured (step 310) (i.e., soft baked) as a precursor to photolithography. In the initial photolithography step (step 320), the edges of the lenses are defined by exposing the resist to ultraviolet (UV) light (e.g., 350 nm - 400 nm) with a photo-mask having an initial pattern masking (step 330), subjecting the resist to a post exposure bake (step 345) and dissolving away unexposed regions of the resist in a developer solution (step 350), leaving one or more stacks of resist material.

If additional layers of resist are to be applied (depending upon the desired height and curvature of the lens) (step 360), each additional layer of resist is spin-coated (step 300) over the previously defined stack(s) of resist, soft-baked (step 310) and photolithographically patterned using a photo-mask having a smaller pattern masking that is capable of defining one or more stacks of resist that are smaller in area than the immediately preceding stacks of resist and that overly one or more of the immediately preceding stacks of resist (step 335). The resist is then baked (step 345), and unexposed areas of resist are dissolved away in developer solution (step 350), leaving a stair case elevation pattern of "pedestals" of resist, where the bottom pedestal of resist has the largest area and the top pedestal of resist has the smallest area.

A final smoothing layer of resist (step 360) is spin-coated over the previous patterned stacks of resist (step 300) and soft-baked (step 310). The final layer (step 325) is also exposed to UV light with the initial photo-mask used in defining the edges of the lenses for the first layer of resist (step 340), subjected to a post exposure bake (step 345) and developed (step 350), such that the final patterned layer of resist covers all other layers of resist. The resulting stack of resist layers (step 360) is thermally cured (step 370) to allow the final layer to flow smoothly over the other resist layers to cover the layers and fill in between the layers. The surface tension of the melted final layer of resist pulls the final resist layer into a lens shape having a curved surface. To finalize the lens shape and size, the lens is blanket exposed (i.e., no mask is used) with UV to cross-link the polymer material in order to harden the lens (step 380). A final thermal treatment can be applied, if necessary, to cure the lenses further to improve performance in subsequent processing (step 390).

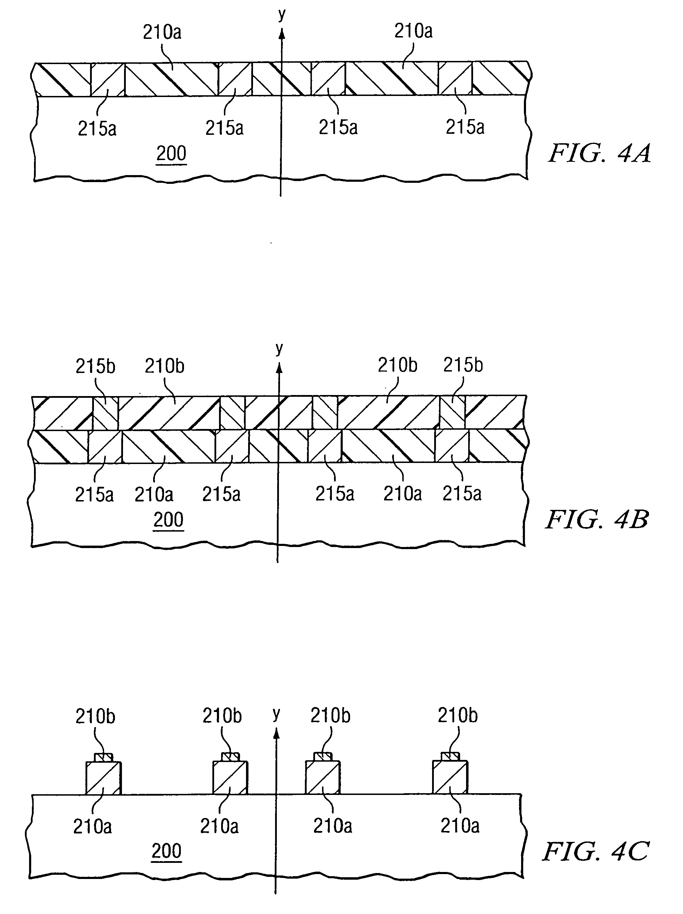

In another embodiment, as shown in FIGs. 4A-4I, an alternate series of pattern steps can be used to fabricate a micro-optics device. First layer of an epoxy-based negative-working photo-definable polymer resist 210a is deposited on substrate 200. First layer of resist 210a is exposed to ultraviolet (UV) light (e.g., 350 nm - 400 nm) with a photo-mask to become cross-linked (i.e., hard) in exposed regions 215a, and therefore, resistant to developer solution. In FIG. 4B, second layer of resist 210b is shown deposited (e.g., spin-coated) over the first layer of resist. Second layer of resist 21 0b is also exposed to UV light using a photo-mask that allows smaller areas 215b of the second layer of resist to be exposed, as compared to first layer of resist 210a. Subsequent layers of resist, not shown, can be deposited and exposed in a stair case elevation pattern, where exposed area 215a of bottom layer 210a has the largest area and exposed area 215b of top layer 21 0b has the smallest area. The unexposed regions of layers of resist 210a and 210b are dissolved together in the developer solution, leaving the desired pattern of one or more stacks 210a and 210b of resist, as shown in FIG. 4C.

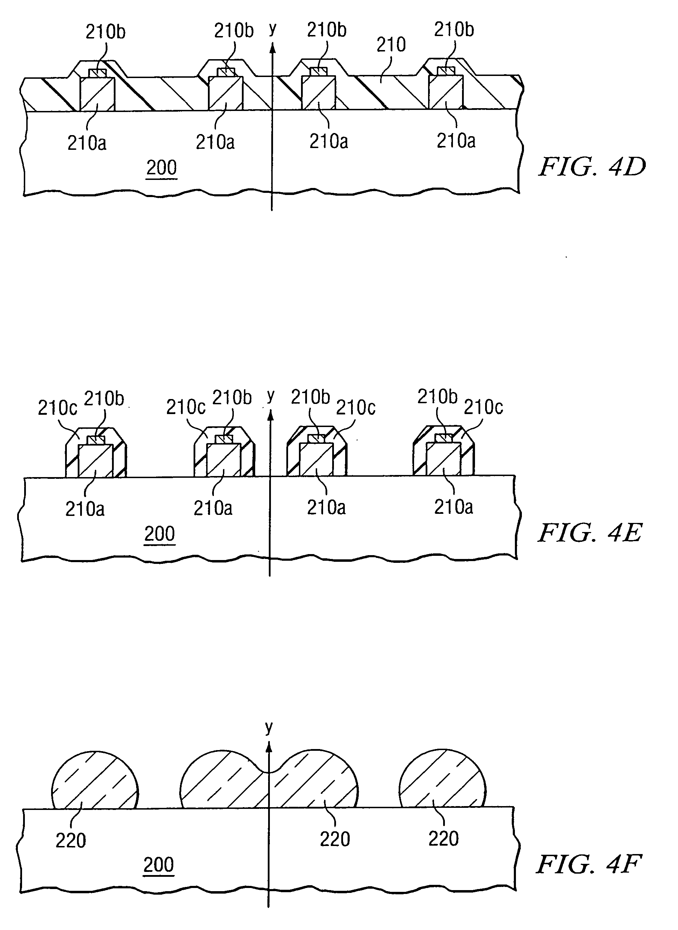

As shown in FIG. 4D, final smoothing layer of resist 210 is spin-coated over previous patterned stacks 210a and 210b of resist. Final layer of resist 210 is also exposed to UV light with the photo-mask used in defining the edges of the lenses for the first layer of resist and developed, such that final patterned layer of resist 210c covers all other stacks 210a and 210b of resist, as shown in FIG. 4E. Resulting stack of resist layers 210a, 210b and 210c is thermally cured (i.e., soft baked) to allow final patterned layer 210c to flow smoothly over other resist stacks 210a and 210b to cover stacks 210a and 210b and fill in between stacks 210a and 210b. Surface tension resulting from the thermal cure process pulls the shape of final patterned layer 210c of resist into lens 220 having a curved surface, as shown in FIG. 4F. To finalize the shape and size of lens 220, lens 220 is blanket exposed (i.e., no mask is used) with UV to cross-link the polymer material in order to harden lens 220.

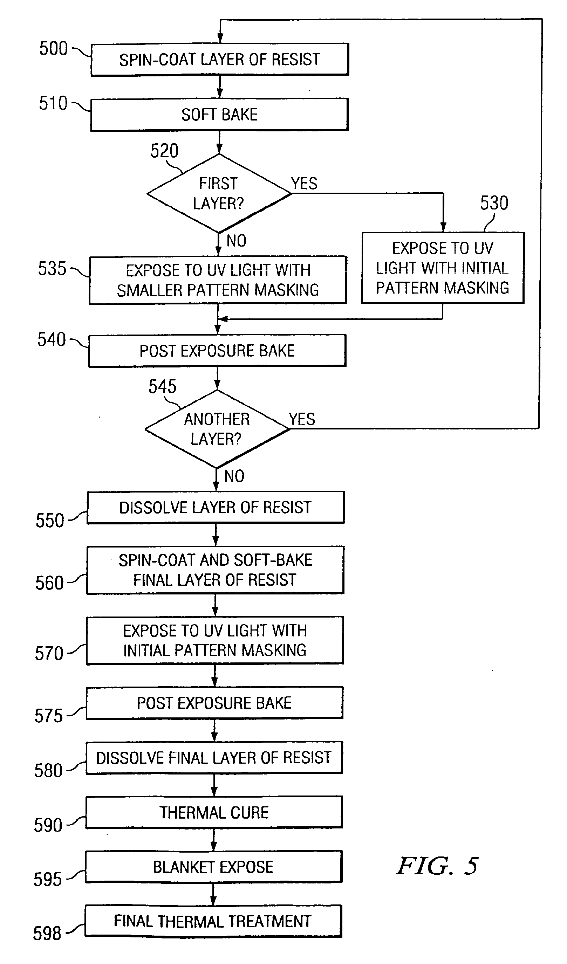

FIG. 5 is a flowchart illustrating exemplary steps for fabricating a micro-optics device in accordance with the embodiment shown in FIGs. 4A-4F. An initial layer of an epoxy-based negative-working photo-definable polymer resist is spin-coated onto a substrate (step 500). If desired, the substrate with the layer of resist thereon can be thermally cured (step 510) (i.e., soft baked) as a precursor to photolithography. In the initial photolithography step (step 520), the edges of the lenses are defined by exposing the resist to ultraviolet (UV) light (e.g., 350 nm ― 400 nm) with a photo-mask with an initial pattern masking (step 530) and baking the resist (step 540) to cross-link (i.e., harden) the resist in the exposed regions. If additional layers of resist are to be applied (depending upon the desired height and curvature of the lens) (step 545), each additional layer of resist is spin-coated (step 500) over the previously defined stack(s) of resist, soft-baked (step 510) and exposed to UV light using a photo-mask having a smaller pattern masking that is capable of defining one or more stacks of resist that are smaller in area than the immediately preceding stacks of resist and that overly one or more of the immediately preceding stacks of resist (step 535). The resist is baked (step 540), and unexposed areas of resist are dissolved away together in developer solution (step 550), leaving a stair case elevation pattern of "pedestals" of resist, where the bottom pedestal of resist has the largest area and the top pedestal of resist has the smallest area.

A final smoothing layer of resist is spin-coated over the previous patterned stacks of resist and soft-baked (step 560). The final layer is also exposed to UV light with the photo-mask used in defining the edges of the lenses for the first layer of resist (step 570), subjected to a post exposure bake (step 575) and developed (step 580), such that the final patterned layer of resist covers all other layers of resist. The resulting stack of resist layers is thermally cured (step 590) to allow the final layer to flow smoothly over the other resist layers to cover the layers and fill in between the layers. The surface tension of the melted final layer of resist pulls the final resist layer into a lens shape having a curved surface. To finalize the lens shape and size, the lens is blanket exposed (i.e., no mask is used) with UV to cross-link the polymer material in order to harden the lens (step 595). A final thermal treatment can be applied, if necessary, to cure the lenses further to improve performance in subsequent processing (step 598).

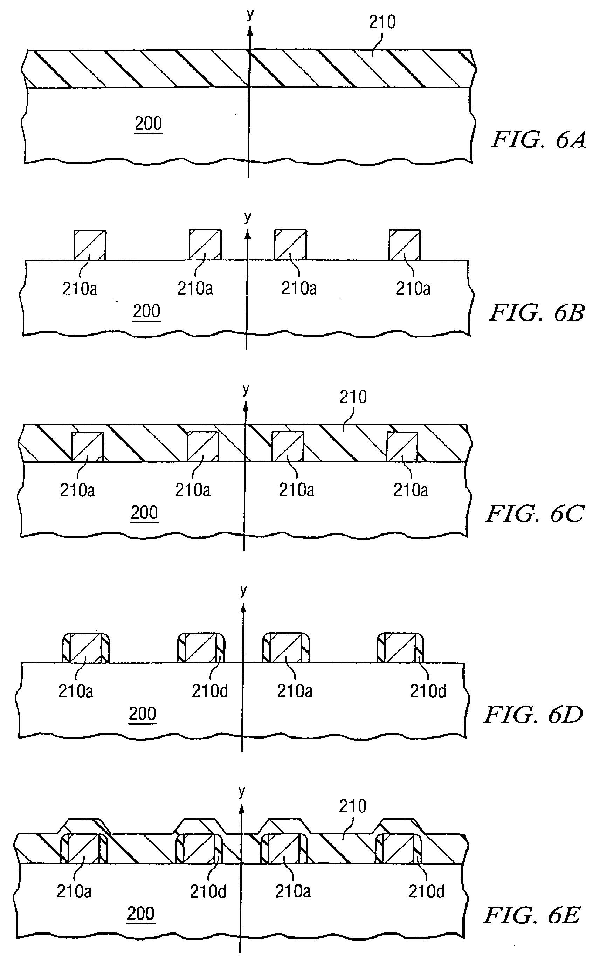

In a further embodiment, as shown in FIGs. 6A-6I, a micro-optics device, such as an array of microlenses, is fabricated in a series of shell steps. As can be seen in FIG. 6A, core layer of an epoxy-based negative-working photo-definable resist 210 is first deposited onto substrate 200. Core layer of resist 210 is patterned photolithographically, as described above. The resulting pattern is one or more core stacks 210a of resist material, as shown in FIG. 6B.

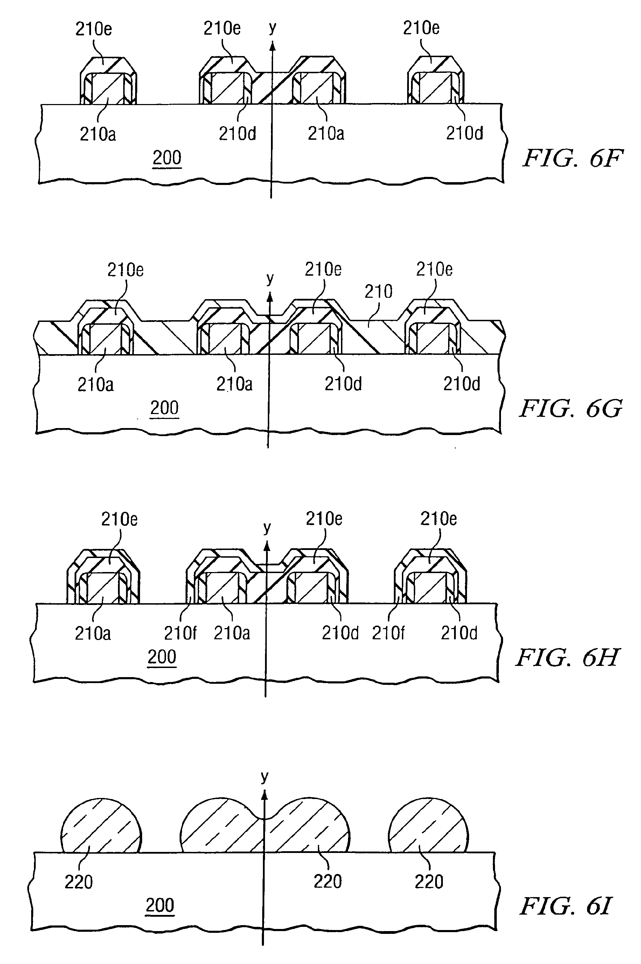

In FIG. 6C, second layer of resist 210 is shown deposited (e.g., spin-coated) over defined core stacks 210a in the first layer of resist. Second layer of resist 210 is dissolved in developer solution without patterning (no UV exposure). Due to loading effects, spacers 210d of resist material are left at the base of each core stack 210a, as shown in FIG. 6D. However, it should be noted that in certain embodiments, spacer 210d resist material may not be needed, and therefore, the micro-optics device can be fabricated using the core layer of resist and any subsequent layer(s) as described below. Subsequent layers of resist 210 can be deposited (e.g., spin-coated) over defined stacks 210a (and spacers 210d) of resist, as shown in FIG. 6E, and patterned photolithographically to define one or more shells 210e of resist overlying one or more stacks 210a (and spacers 210d) of resist. As shown in FIG. 6F, each shell 210e of resist material has a larger area than the combination of stack 210a and spacers 210d. The edges of resist shell 210e define the diameter of the lens. The number of shells 210e used depends upon the desired height, width and curvature of the lens.

As shown in FIG. 6G, final smoothing layer of resist 210 is spin-coated over previous patterned shells 210e of resist and patterned photolithographically to define final shell 210f of resist, as shown in FIG. 6H. Resulting shells 210e and 210f of resist are thermally cured (i.e., soft baked) to allow final shell 210f of resist to flow smoothly over other resist shells 210e, and to allow surface tension resulting from the thermal cure process to pull the shape of final shell 210f of resist into lens 220 having a curved surface. To finalize the shape and size of lens 220, as shown in FIG. 6I, lens 220 is blanket exposed (i.e., no mask is used) with UV to cross-link the polymer material in order to harden lens 220. By defining a series of shells 210e and 210f, resulting lens 220 will have smooth round sidewalls with a hemispherical shape.

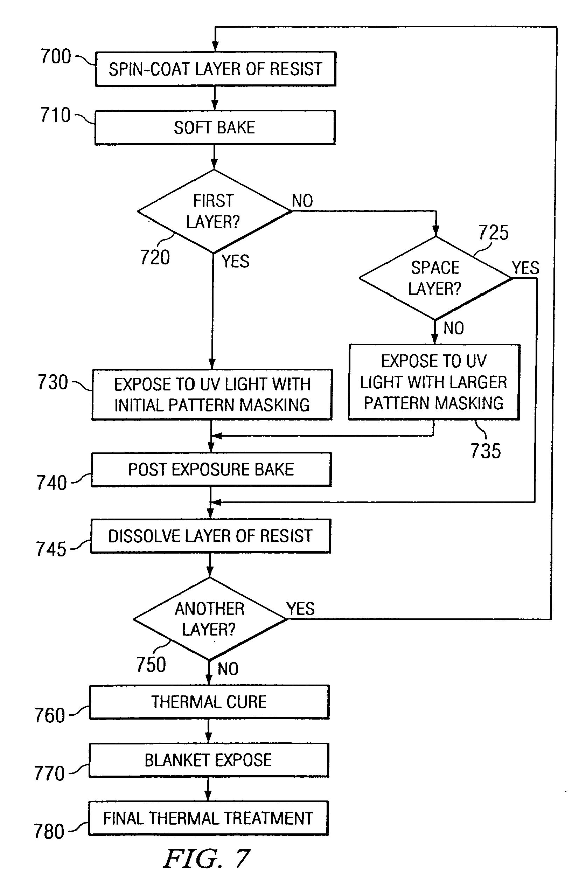

FIG. 7 is a flowchart illustrating exemplary steps for fabricating a micro-optics device in accordance with the embodiment shown in FIGs. 6A-6I. A core layer of an epoxy-based negative-working photo-definable polymer resist is spin-coated onto a substrate (step 700). If desired, the substrate with the layer of resist thereon can be thermally cured (step 710) as a precursor to photolithography. In the initial photolithography step (step 720), the core layer of resist is patterned by exposing the resist to ultraviolet (UV) light (e.g., 350 nm ― 400 nm) with a photo-mask having an initial pattern masking (step 730), subjecting the resist to a post exposure bake (step 740) and dissolving away unexposed regions of the resist in a developer solution (step 740), leaving one or more core stacks of resist material.

If one or more spacers of resist material are desired to widen the lens without increasing the height of the lens (step 750), one or more additional layers of resist can be spin-coated over the defined core stacks in the first layer of resist (step 700), soft-baked (step 710) and, to define the spacers (step 725), dissolved in developer solution without patterning (no UV exposure) (step 745). Thereafter, if additional layers of resist are to be applied (depending upon the desired height and curvature of the lens) (step 750), each additional layer of resist is spin-coated over the previously defined core stack and spacers of resist (step 700), soft-baked (step 710) and photolithographically patterned using a photo-mask having a larger pattern masking that is capable of producing one or more shells of resist that are larger in area than the combination of the core stack and spacers of resist and that overly one or more of the core stacks and spacers of resist (step 735). The resist is baked (step 740), and unexposed areas of resist are dissolved away in developer solution (step 740), leaving a stack of "shells", where the bottom core stack has the smallest area and the top shell has the largest area.

A final smoothing layer of resist (step 750) is spin-coated over the previous patterned shells of resist (step 700) and soft-baked (step 710). The final layer is also exposed to UV light (step 735), subjected to a post exposure bake (step 740) and developed (step 740), such that the final patterned layer of resist covers all other layers of resist. The resulting shells of resist are thermally cured (step 760) to allow the final layer to flow smoothly over the other resist layers, and to allow the surface tension of the melted final layer of resist to pull the final resist layer into a lens shape having a curved surface. To finalize the lens shape and size, the lens is blanket exposed (i.e., no mask is used) with UV to cross-link the polymer material in order to harden the lens (step 770). A final thermal treatment can be applied, if necessary, to cure the lenses further to improve performance in subsequent processing (step 780).

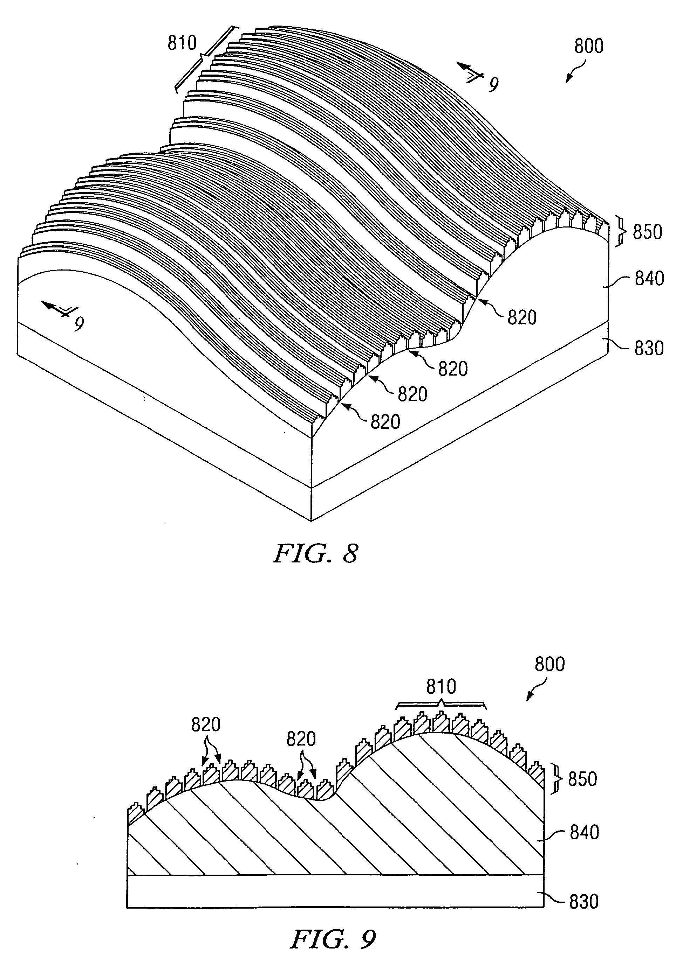

The fabrication techniques described above in connection with FIGs. 1-7 can be used to create a variety of three-dimensional optical devices with unique structures and properties. For example, referring now to FIGs. 8 and 9, there is illustrated an exemplary optical device 800 with refractive and diffractive properties that can be fabricated in accordance with embodiments of the present invention. FIG. 8 is a perspective view of the exemplary optical device 800. FIG. 9 is a cross-sectional view of the optical device 800 of FIG. 8. The optical device 800 shown in FIGs. 8 and 9 combines a large-scale curved surface-relief pattern, with a fine-detailed, microscopic diffractive pattern in order to produce a high performance, high functionality optical device with both refractive and diffractive properties.

More specifically, the optical device 800 shown in FIGs. 8 and 9 includes a large-scale, curved-surface discrete relief structure 840 disposed over a substrate 830 and a fine-detailed, diffractive discrete relief structure 850 disposed over the curved-surface discrete relief structure 840. Each of the discrete relief structures 840 and 850 are formed of an optically-transparent polymer material, such as an epoxy-based polymer material. The curved-surface discrete relief structure 840 can be fabricated as discussed above, and has a curved surface that provides refractive properties to perform the majority of the focusing and steering of light. The diffractive discrete relief structure 850 includes a surface curvature envelope 810 formed of discontinuous diffractive features 820. The discontinuous diffractive features 820 introduce diffractive properties into the optical device 800, such as beam splitting, grating spectroscopy, or computer generated holography.

Although the diffractive properties could be implemented using a pure diffractive surface, the efficiency and resulting performance of the optical device would be low. Therefore, by allowing a curved-surface discrete relief structure 840 to perform the majority of the focusing, the diffractive features 820 can be efficiently implemented and uniquely designed. In addition, the present invention is not limited to the particular shape or design of the curved-surface discrete relief structure 840 or the diffractive discrete relief structure 850 of the optical device 800 shown in FIGs. 8 and 9, but instead is intended to include any arbitrary three-dimensional optical device fabricated in accordance with embodiments of the present invention to provide refractive and diffractive properties. Furthermore, the optical device 800 can be fabricated in mass production using a "master molding."

As can be seen in FIG. 9, the discontinuous diffractive features 820 include sets of fine-scale diffractive steps that create a high-frequency diffraction grating with sharp, discontinuous features. The sets collectively form the overall surface curvature envelope 810. Each set includes a number of diffractive steps designed to provide the desired diffractive properties and to form the surface curvature envelope 810 of the optical device 800 from the top layer (top step) of each set. Thus, the surface curvature envelope 810 of the optical device 800 is produced by controlling the number of steps and the height of each step in adjacent sets of diffractive steps.

For example, in one embodiment, each of the sets of diffractive steps is fabricated by separately photolithographically patterning one or more layers of the optically-transparent polymer resist material. For example, the diffractive steps in each set can be fabricated as described above in connection with FIGs. 2A-2D or FIGs. 4A-4C. However, the diffractive discrete relief structure is not reflowed (i.e., thermally cured) in order to maintain the sharp, discontinuous diffractive features 820. To finalize the optical device 800, the optical device 800 is blanket exposed (i.e., no mask is used) with UV to cross-link the polymer material in order to harden the optical device 800.

In an exemplary embodiment, the diffractive discrete relief structure 850 of the optical device 800 produces an overall sag (depth) between 0-50 µm. In addition, the diffractive features 820 (diffractive steps) each have individual step heights of 0.1 to 1.5 µm, and the total stacked thickness of the optical device 800 ranges from 0.25 to 3.0 µm. Furthermore, the lateral dimension of each of the diffractive features 820 ranges from 0.4 to 10+ µm.

As will be recognized by those skilled in the art, the innovative concepts described in the application can be modified and varied over a wide range of applications. Accordingly, the scope of patented subject matter should not be limited to any of the specific exemplary teachings discussed, but is instead defined by the following claims.

## Claims

1. An optical device (800) with refractive properties and diffractive properties, comprising:
a substrate (830);
a first discrete relief structure (840) disposed over said substrate (830), said first discrete relief structure (840) having a curved surface to provide said refractive properties; and
one or more layers of an optically-transparent polymer material disposed over said first discrete relief structure to define a surface curvature envelope (810) of a second discrete relief structure (850), said surface curvature envelope (810) being formed of discontinuous diffractive features (820) to provide said diffractive properties.

2. The device of Claim 1, wherein said first discrete relief structure (840) comprises:
at least one additional layer of said optically-transparent polymer material disposed on said substrate (830) and photolithographically patterned to define said curved surface.

3. The device of Claim 1, wherein said discontinuous diffractive features (820) include sets of diffractive steps, each of said sets formed of stacked ones of said two or more layers, and wherein said surface curvature envelope (810) is formed from a top one of said one or more layers in each of said sets.

4. The device of Claim 3, wherein each of said sets includes a first stack of said optically-transparent polymer material and at least one additional stack of said optically-transparent polymer material overlying said first stack, said at least one additional stack having an area less than an area associated with said first stack.

5. The device of Claim 3, wherein a height of each of said diffractive steps is between 0.1 µm and 1.5 µm.

6. The device of Claim 1, wherein a lateral dimension of each of said discontinuous diffractive features (820) is between 0.4 µm and 10 µm.

7. The device of Claim 1, wherein a sag of said first discrete relief structure (840) is between 0 µm and 50 µm.

8. The device of Claim 1, wherein said optically-transparent polymer material is formed of an epoxy-based polymer material.

9. The device of Claim 1, wherein each of said one or more layers are separately patterned photolithographically.

10. The device of Claim 1, wherein said diffractive properties include beam splitting, grating spectroscopy and holography.
